# EUROPEAN PATENT SPECIFICATION

(11) **EP 3 182 445 B1**
(45) Date of publication and mention of the grant of the patent: **18.11.2020**
(21) Application number: 15200095.6
(22) Date of filing: 15.12.2015
(51) Int. Cl.: H01L 23/31, H01L 21/762, H01L 23/29, H01L 29/205, H01L 29/66, H01L 29/778, H01L 29/872, H01L 29/40

(54) **SEMICONDUCTOR DEVICE AND METHOD OF MAKING A SEMICONDUCTOR DEVICE**
HALBLEITERBAUELEMENT UND VERFAHREN ZUR HERSTELLUNG EINES HALBLEITERBAUELEMENTS
DISPOSITIF DE SEMI-CONDUCTEUR ET PROCÉDÉ DE PRODUCTION D'UN TEL DISPOSITIF

(43) Date of publication of application: 21.06.2017
(73) Proprietor: Nexperia B.V., 6534 AB Nijmegen (NL)
(72) Inventor: Ritter, Hans-Martin, Redhill, Surrey RH1 1SH (GB); Utzig, Joachim, Redhill, Surrey RH1 1SH (GB); Burmeister, Frank, Redhill, Surrey RH1 1SH (GB); Notermans, Godfried Henricus Josephus, Redhill, Surrey RH1 1SH (GB); Wynants, Jochen, Redhill, Surrey RH1 1SH (GB); Mintzlaff, Rainer, Redhill, Surrey RH1 1SH (GB)
(74) Representative: Pjanovic, Ilija

(56) References cited:
- DE-A1- 19 806 819
- US-A- 5 381 033
- US-A1- 2002 031 897
- US-A1- 2012 292 736

## Description

### BACKGROUND

The present specification relates to a semiconductor device and to a method of making a semiconductor device.

The ongoing miniaturisation of semiconductor devices has led to a need to miniaturise device packages in ways that do not adversely affect the electrical performance of the device.

In the field of discrete devices this trend has led to chip scale packages (CSPs). This type of package generally includes a semiconductor die having a major surface and a backside. Electrical contacts of the device are provided on the major surface. The package may be surface mounted on a carrier such as a printed circuit by placing it on the carrier with the major surface facing downwards. This may allow the contacts on the major surface to be soldered to corresponding contacts on the carrier. Chip scale packages may use little or no mould compound (encapsulant).

Chip scale packages (CSPs), especially flip chip packages, can provide having a relatively large substrate volume with a relatively small package size. In some CSPs, nearly 100% of the package volume is silicon.

US 2002/0031897 relates to the formation of a plurality of trench isolation structures in a semiconductor device.

US 2012/0292736 relates to the formation of via structures to separate digital and analogue portions of combined analogue and digital designs.

DE 19806819 relates to the formation of semiconductor islands insulated from each other in a semiconductor wafer.

### SUMMARY

A semiconductor device in accordance with the present invention is defined in claim 1. A method of making a semiconductor device in accordance with the invention is defined in claim 11.

The first part of the substrate may include an active region of the semiconductor device and the second part of the substrate may include a sidewall of the substrate that extends between the major surface and the backside. In this example, the dielectric partition may electrically isolate the sidewall of the substrate from the active region. This may prevent electrical shorting between the active region and any solder that may be used to mount the device, should the solder come into contact with the sidewall. It is envisaged that the part of the substrate including the sidewall may not itself include an active region of the device. In some examples, the part of the substrate including the sidewall may be thin compared to the dimensions of a part of the substrate including an active region (e.g. around 1-3%), thereby allowing the overall size of the device to be reduced.

The first part of the substrate may include a first active region of the semiconductor device and the second part of the substrate may include a second active region of the semiconductor device. In this example, the dielectric partition may be used to electrically isolate the first and second active regions from each other.

The dielectric partition is shaped to define at least one interlocking portion in the substrate. In some examples the (or each) dielectric partition of the semiconductor device may include a plurality of such interlocking portions.

The interlocking portion(s) comprises a locking member located on one side of the dielectric partition and an opening located on an opposite side of the dielectric partition. The locking member is received within the opening to inhibit physical separation of the parts of the substrate that the dielectric partition electrically isolates. The shape of the opening is conformal with the shape of the locking member.

In some examples, the locking member of the at least one interlocking portion may include a neck portion and a head portion. The opening may include a mouth portion within which the neck portion of the locking member may be received. The head portion of the locking member may be at least as wide as the mouth portion of the opening when viewed from above the major surface, to prevent removal of the head portion from the opening. In some examples, the head portion of the locking member may be wider than the mouth portion of the opening.

Various different shapes for the locking member are envisaged. For instance, the locking member may be substantially trapezoidal in shape when viewed from above the major surface. In some examples, the edges of the locking member may be curved when viewed from above the major surface.

The dielectric partition includes at least one corner when viewed from above the major surface of the substrate. The layout of the dielectric partition, including one or more corners may, for instance, allow the dielectric partition to at least partially surround a part of the substrate.

In some examples, the semiconductor device may comprise at least one further dielectric partition. At least some of the dielectric partitions may intersect. The layout of the dielectric partitions, including one or more intersections may, for instance, allow the dielectric partitions to at least partially surround a part of the substrate.

The substrate may include at least one further part. The first part, the second part and each further part of the substrate may electrically isolated from neighbouring parts by one or more dielectric partitions of the kind described herein. For instance, this may allow multiple active regions of the device to be isolated from each other and/or may allow those active regions to be isolated from the sidewalls of the substrate.

According to a further aspect of the present disclosure, there is provided a chip scale package comprising a semiconductor device of the kind described above.

### BRIEF DESCRIPTION OF THE DRAWINGS

Embodiments of this disclosure will be described hereinafter, by way of example only, with reference to the accompanying drawings in which like reference signs relate to like elements and in which:
Figure 1 shows a semiconductor device according to an example not forming part of the present invention;
Figure 2 shows a semiconductor device according to another example;
Figure 3 shows a semiconductor device according to a further example;
Figure 4 shows a semiconductor device of the kind shown in Figure 3 mounted on a carrier such as a printed circuit board (PCB);
Figures 5A-5C show a method for making a semiconductor device in accordance with another example not forming part of the present invention;
Figure 6 shows a semiconductor device according to a first embodiment of the present invention;
Figure 7 shows a dielectric partition having a plurality of interlocking portions in accordance with an embodiment of the present invention;
Figure 8 shows an interlocking portion of the kind shown in Figures 6 and 7 in more detail; and
Figures 9A-9C each show further examples of a dielectric partition for a semiconductor device in accordance with an embodiment of the present invention.

### DETAILED DESCRIPTION

Examples as well as embodiments of the invention are described in the following with reference to the accompanying drawings.

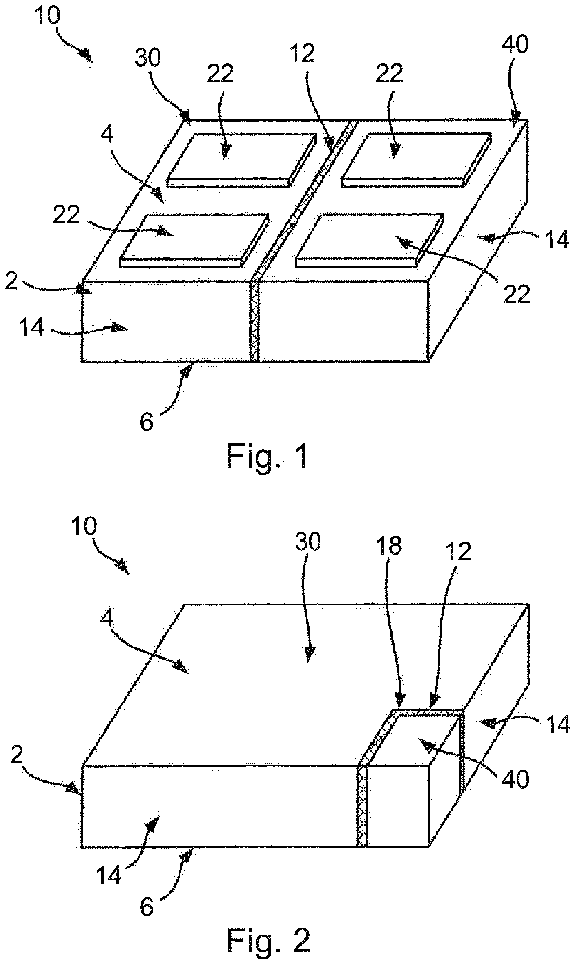

Figure 1 shows a semiconductor device 10 according to an example useful for understanding the present invention. The device 10 includes a substrate 2. The substrate 2 may be a semiconductor substrate comprising, for instance, silicon. The substrate 2 has a major surface 4 and a backside 6. The substrate 2 may include a number of sidewalls 14, which extend between the major surface 4 and the backside 6 at the edges of the substrate 2.

The device 10 also includes one or more electrical contacts 22 located on the major surface. The electrical contacts 22 may be metallic. For instance, the contacts 22 may comprise one or may layers of metal stacked on the major surface 4. The contacts 22 may, for instance, formed solder pads for allowing solder to be used to mount and electrically connect the device 10 to a surface of a carrier. Accordingly, the device 10 may be a chip scale package, which may be mountable on a surface of a carrier such as a printed circuit board (PCB).

In this example, the substrate 2 includes a first part 30 and a second part 40. The first part 30 in this example includes an active region including one or more components (e.g. active components such as transistor or diodes), which may be connected to the contacts 22 located in that part. Similarly, the second part 40 in this example includes an active region including one or more components (e.g. active components such as transistor or diodes), which may be connected to the contacts 22 located in that part.

The device 10 also includes a dielectric partition 12. The dielectric partition 12 may extend through the substrate 2 from the major surface 4 to the backside 6 such that the first part 30 of the substrate 2 does not physically contact the second part 40 of the substrate 2. Accordingly, the dielectric partition may electrically isolate the first part 30 of the substrate 2 from the second part 40 of the substrate 2. In the present example, this may allow the active regions in each respective part 30, 40 of the substrate 2 to be electrically isolated from each other. This may, for instance, allow the components in each active region to operate substantially independently from each other, preventing e.g. unwanted cross talk between the components in the different active regions.

Figure 2 shows a semiconductor device 10 according to an example not forming part of the present invention. The device 10 includes a substrate 2, which as noted previously may be a semiconductor substrate comprising, for instance, silicon. The substrate 2 has a major surface 4 and a backside 6. Like the example of Figure 1, the substrate 2 may include a number of sidewalls 14, which extend between the major surface 4 and the backside 6 at the edges of the substrate 2.

The substrate 2 in this example includes a first part 30 and a second part 40. As with the example of Figure 1, the device 10 includes a dielectric partition 12, which may extend through the substrate 2 from the major surface 4 to the backside 6 such that the first part 30 of the substrate 2 does not physically contact the second part 40 of the substrate 2. Accordingly, the dielectric partition may electrically isolate the first part 30 of the substrate 2 from the second part 40 of the substrate 2.

In the example of Figure 2, the dielectric partition 12 includes a corner 18. The provision of one or more corners 18 in the dielectric partition 12 may allow the layout of the dielectric partition 12 to be determined with greater flexibility compared to the example of Figure 1. For instance, the dielectric partition 12 in the example of Figure 2 allows a corner part (the second part 40 in Figure 2) to be electrically isolated from the remainder of the substrate 2. Each part 30, 40 of the substrate may, for instance, include active regions which may be electrically isolated from each other by the dielectric partition 12 as noted above in relation to Figure 1.

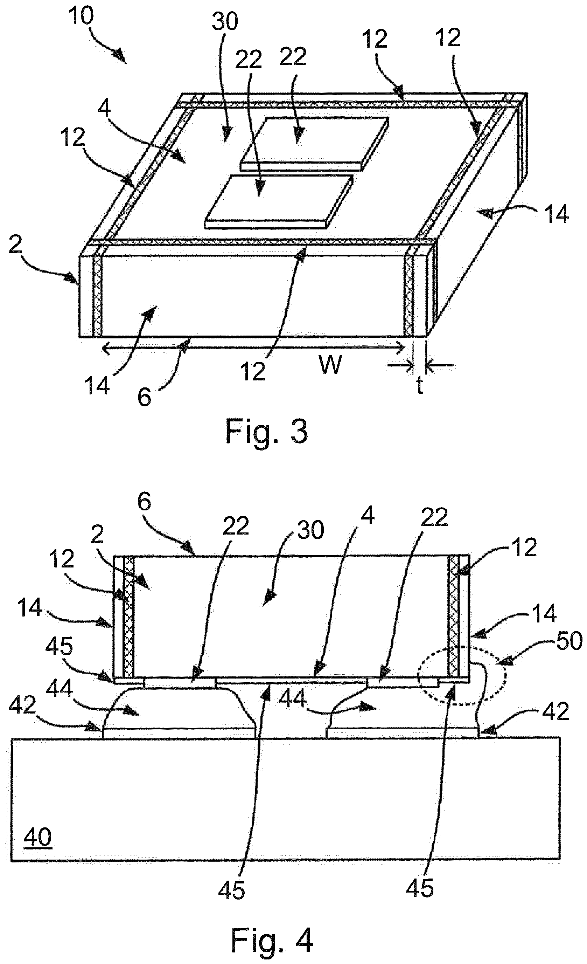

Figure 3 shows a semiconductor device 10 according to a further example useful for understanding the present invention. The device 10 includes a substrate 2, which as noted previously may be a semiconductor substrate comprising, for instance, silicon. The substrate 2 has a major surface 4 and a backside 6. Like the examples of Figure 1 and Figure 2, the substrate 2 includes a number of sidewalls 14, which extend between the major surface 4 and the backside 6 at the edges of the substrate 2.

The substrate 2 in this example includes a first part 30 which includes an active region of the kind described previously in relation to Figures 1 and 2. One or more contacts 22 of the kind described above in relation to Figure 1 may be located on the major surface 4 in the first part 30 of the substrate 2.

In this example, the device 10 includes a plurality of dielectric partitions 12. These dielectric partitions 12 intersect with each other at the corners of the first part 30 of the substrate 30 as shown in Figure 3. As described previously, each dielectric partition 12 may extend through the substrate 2 from the major surface 4 to the backside 6. Each of the dielectric partitions 12 in this example electrically isolates the first part 30 of the substrate 2 from another part of the substrate which includes one of the sidewalls 14. The thickness t of the parts of the substrate 2 including the sidewalls 14 may be thin (e.g. ≈ 1-3%) compared to the width W of the first part 30 in the same direction. For instance, the parts of the substrate 2 including the sidewalls 14 may be around t ≈ 1-5µm thick and the width of the first part 30 in the same direction may be a few hundred microns, e.g. around W ≈ 300µm.

It is envisaged that instead of using multiple intersecting dielectric partitions 12 as shown in Figure 2, the first part 30 of the substrate 2 may be electrically isolated from the sidewalls 14 of the substrate 2 using a single, box shaped dielectric partition 12 having four corners (of the kind described above in relation to Figure 2), which surrounds the first part 30 of the substrate 2 on each side.

Figure 4 shows the device 10 of Figure 3 surface mounted, with the major surface 4 facing downwards, on a carrier such as a printed circuit board (PCB). The PCB may include one or may contacts such as solder pads 42 to allow the device to be mounted using portions of solder 44, which provide electrical connections between the carrier and the contacts 22 on the major surface 4. Figure 4 also shows that in some examples, a protective layer 45 (such as a dielectric) may be located on the major surface 4, thereby to prevent any of the solder 44 that is used to mount the device 10 coming directly into contact with the major surface 4. If the solder 44 did contact the major surface 4 directly, this may cause unwanted electrical shorting between the solder 44 and the device 10 (e.g. to an active region in the first part 30).

As can be seen in Figure 4, when solder is used to implement this kind of surface mounting, it can occasionally occur that some of the solder 44 may inadvertently make contact with the sidewalls 14 (this is indicated in Figure 4 by the dotted region labelled using reference numeral 50). Were the sidewalls 14 of the substrate 2 in this example not isolated from the first part 30 including the active region, this may lead to electrical shorting between the contacts 22, 42 and the active region of the device 10 via the part of the solder 44 contacting the sidewall 14, which may lead to incorrect operation of the device 10 or even device failure. Moreover, in the example of Figure 4, the dielectric partitions 12 may allow each of the different parts of the substrate 2 including a respective sidewall 14 to be isolated from each other, which may prevent electrical shorting between different contacts 22, 42 of the device 10 and/or carrier 40 via the sidewalls, in the event that the solder used to mount the device 10 makes contact with more than one sidewall 14.

It is envisaged that the active region(s) of a device 10 of the kind described in relation to Figure 4 need not be isolated from all of the sidewalls 14 of the substrate 2. For instance, dielectric partition(s) 12 of the kind shown in Figure 4 may be provided just to isolated the active regions from sidewalls 14 that relatively close to the contacts 22 on the major surface 4. For sidewalls that are located some distance away from any of the contacts 22, the risk of any solder used to connect to the contacts 22 actually touching the sidewalls 14 may be relatively low. Nevertheless, it will be appreciated that contacts 22 may be placed relatively close to the edges of the substrate 2 while avoiding the electrical shorting problem noted above, which may allow the overall size of the device 10 to be reduced.

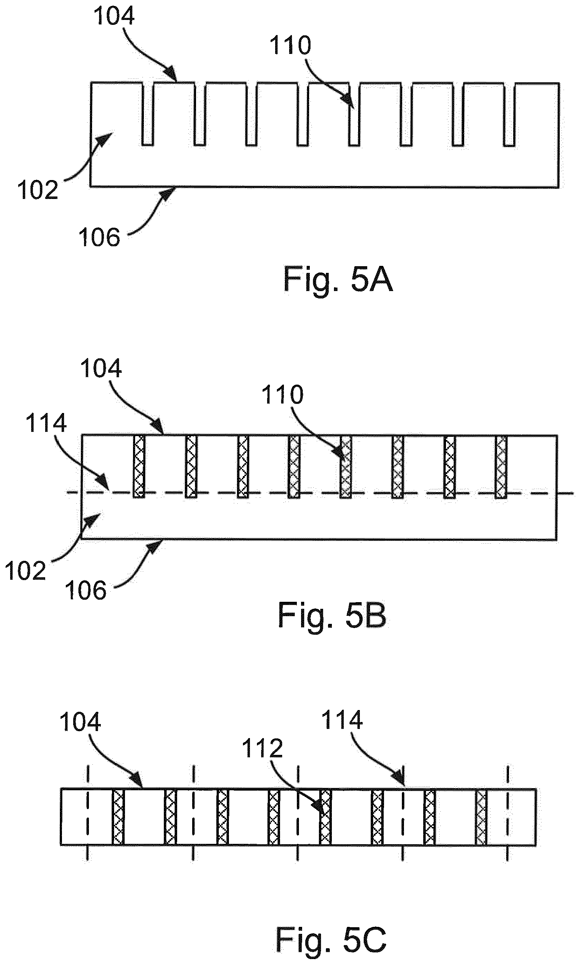

Figures 5A-5C show a number of steps in an example of a method for making a semiconductor device that is useful for understanding the present invention. In this example, the device is a wafer-level chip scale package (WLCSP).

In a first step shown in Figure 5A, a wafer 102 is provided. The wafer 102 may be a semiconductor wafer comprising, e.g. silicon. The wafer 102 has a major surface 104 and a backside 106. One or more active regions may be formed in the wafer 102 using standard semiconductor manufacturing techniques and one or more contacts may be formed on the major surface 104 of the wafer 102 to provide electrical connections to these active regions. It is envisaged that the active regions and/or the contacts on the major surface may be formed either prior to or after the formation of the trenches and corresponding dielectric partitions to be described below. For clarity, the active regions and contacts are not shown in Figures 5A-5C.

At least one trench 110 is formed in the wafer 102. The trench(es) 110 may, for instance, be formed using lithographic techniques in which the major surface is masked and etched. In another example, laser etching may be used. The trench(es) 110 extend from the major surface 104 at least partially through the wafer 102. As represented by the dashed line 114 in Figure 5B, the depth of the trench(es) may be chosen to be substantially equal to, or deeper than, the thickness of the wafer after the back grinding step described below.

In a next step shown in Figure 5B, the trench(es) are at least partially filled with dielectric. The dielectric may be formed, for instance, by:
- Filling the trench(es) with (Low Pressure Chemical Vapor Deposition (LPCVD)) deposited oxide;
- thermal oxidation the sidewalls of the trench(es), and filling the remainder of the trench(es) with undoped LPCVD polysilicon; or
- Using polyimide or a similar spin-on polymer.

The choice of methods and materials at least partially filling the trench(es) may depend, for instance, on the width of the trench(es).

In the present example, the trench(es) 110 are completely filled with dielectric. It will be appreciated that the layout of the trench(es) 110 formed in Figure 5A may be chosen such that, following singulation of the wafer as described below, the trench(es) 110 filled with dielectric form the dielectric partitions 112 of the kind described herein.

After the trench(es) 110 have been at least partially filled with dielectric, material may be removed from the backside 106 of the wafer 102, e.g. by back-grinding the wafer 102. This material may be removed at least until the bottoms of the trench(es) 110 are exposed. As can be seen in Figure 5C, this results in the formation of one or more dielectric partitions 12 corresponding to the trenches 110 filled with dielectric.

In a next step, represented by the dashed lines 114 in Figure 5C, the wafer may be singulated (diced) to form a plurality of semiconductor substrates. Each substrate may be a substrate of a semiconductor device of the kind described herein. Note that the major surface of the substrates may correspond to the major surface 104 of the wafer 102, while the backside of each substrate may correspond to the back grinded backside 106 of the wafer 102.

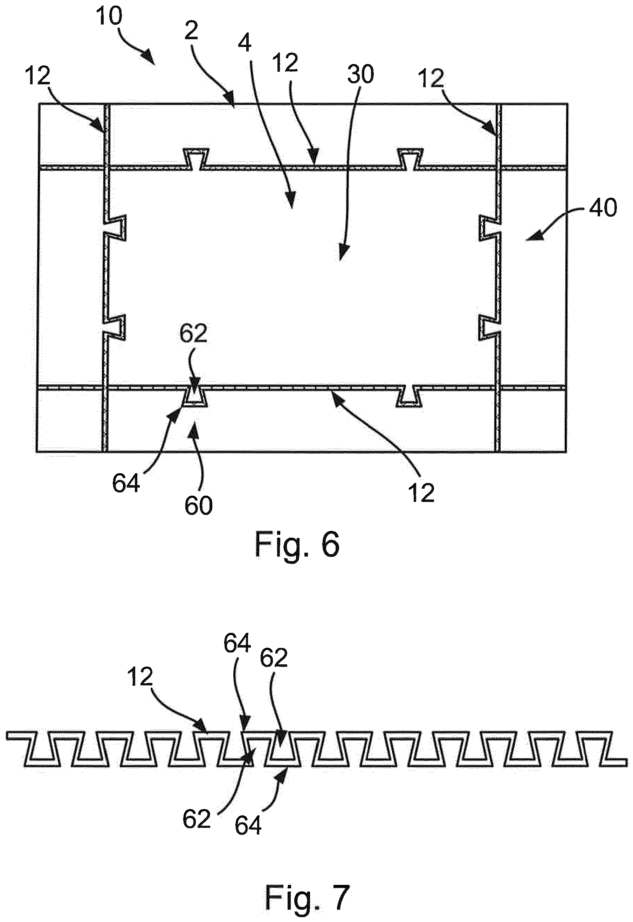

Figure 6 shows a semiconductor device 10 according to a first embodiment of the present invention. The device 10 includes a substrate 2, which as noted previously may be a semiconductor substrate comprising, for instance, silicon. The substrate 2 has a major surface 4 and a backside. Like the example of Figure 1, the substrate 2 may include a number of sidewalls, which extend between the major surface 4 and the backside at the edges of the substrate 2. The view of the device 10 in Figure 6 is from above the major surface 4, and as such the backside and sidewalls are not visible.

The substrate 2 in this embodiment includes a first part 30, which may include an active region of the device 10. The substrate includes a number of other parts, such as second part 40, which includes one of the sidewalls of the substrate 2. In other examples, the second part 40 may include another active region of the device, as explained previously in relation to Figure 1.

The device 10 includes a number of dielectric partitions 12 which may extend through the substrate 2 from the major surface 4 to the backside as explained previously. In the present embodiment the device 10 includes four dielectric partitions 12, which intersect in a number of locations and which electrically isolate the first part 30 of the substrate 2 from parts of the substrate 2 (such as the second part 40) which include sidewalls of the substrate 2. The layout of the dielectric partitions 12 in this example is therefore similar to that described in relation to Figure 3.

In accordance with embodiments of this disclosure, at least some of the dielectric partitions 12 are shaped to define at least one interlocking portion in the substrate 2. These interlocking portions each comprise a locking member 62 located on one side of the dielectric partition 12 and an opening 64 located on an opposite side of the dielectric partition 12. The locking member 62 is received within the opening 64. Each opening 64 is shaped to conform with the shape of the locking member 62 received within it.

As will be described below in more detail, the locking member 62 is shaped to oppose its removal from the opening 64. The interlocking portion may thus improve the mechanical robustness of the device 10 by inhibiting physical separation of the parts of the substrate 2 that the dielectric partition 12 electrically isolates. The provision of interlocking portions of the kind described herein may thus address the potential structural weakness introduced into the substrate 2 by the presence of the dielectric partitions 12.

In the present embodiment each dielectric partition 12 includes two such interlocking regions, as can be seen in Figure 6. The locking members 62 may be oriented to extend substantially transverse to the direction in which the dielectric partition 12 itself extends. It will be appreciated that the locking members 62 may be located on either side of the dielectric partition 12, and the openings 64 may be provided on the opposite side of the dielectric partition 12 to receive the locking members 62. For instance, in the embodiment of Figure 6, some of the locking members 62 extend outwardly with respect to the first part 30 of the substrate 2, while others of the locking members 62 extend inwardly with respect to the first part 30 of the substrate 2.

In the embodiment of Figure 6, the interlocking portions 60 of each dielectric partition 12 are separated by intervening straight sections of the dielectric partition 12. The interlocking portions 60 may be located at regular intervals along the or each dielectric partition 12. The spacing between adjacent interlocking portions 60 may be determined by the length of the dielectric partition 12 and the number of interlocking portions 60 that it includes. It is envisaged that the spacing between adjacent interlocking portions 60 may vary over the length of the dielectric partition 12.

In the embodiment of Figure 7, a dielectric partition 12 includes a plurality of interlocking portions 60 which are located adjacent each other along the dielectric partition 12. In this embodiment, since the interlocking portions 60 are located adjacent each other, they are not separated by straight sections of the kind described above. It is envisaged though that in some embodiments, a dielectric partition 12 may be provided with one or more groups of adjacent interlocking portions 60 of the kind shown in Figure 7, with each group being separated by one or more straight sections.

In the embodiment of Figure 7, note that the locking members 62 of adjacent interlocking portions 60 are located on opposite sides of the dielectric partition 12, and that correspondingly the openings 64 of adjacent interlocking portions 60 are also located on opposite sides of the dielectric partition 12.

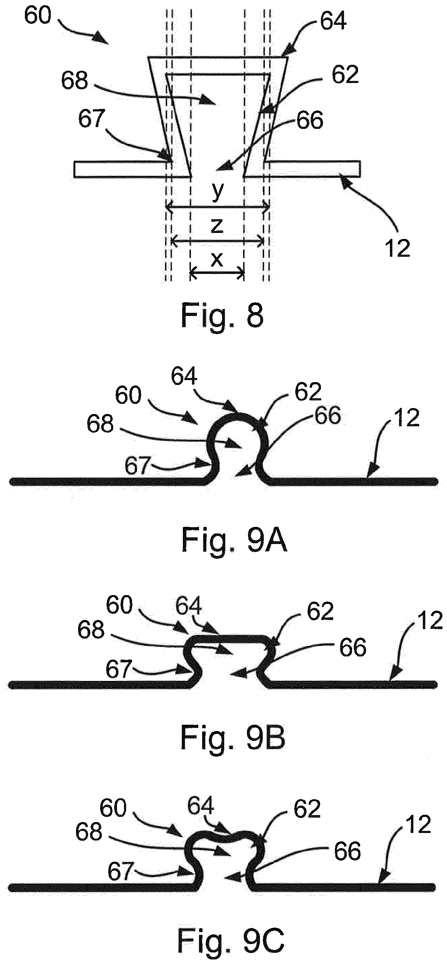

Figure 8 shows an interlocking portion 60 of the kind shown in Figures 6 and 7 in more detail. In this embodiment, the locking member 62 includes a neck portion 66 and a head portion 68. At its widest point (denoted dimension "X" in Figure 8), the head portion 68 is wider than the narrowest part of the neck portion 66 (denoted dimension "Y" in Figure 8) when viewed from above the major surface of the substrate. The opening includes a mouth portion 67, which may typically be the narrowest part of the opening 64. As shown in Figure 8, the neck portion of the locking member 62 may be located in the mouth portion 67 of the opening 64.

The shape of the neck portion 66, head portion 68 and mouth portion 67 may assist in retaining the locking member 62 within the opening 64. For instance, the widest point of the head portion 68 may be at least as wide as (or in some examples, as in Figure 8, wider than) the width of the mouth portion 67 of the opening 64 (denoted dimension "Z" in Figure 8) when viewed from above the major surface of the substrate.

It is envisaged that the dimensions of the features of the interlocking portions 60 in a given device 10 may not be equal. For instance, larger locking members 62 may be used in certain parts of the device 10, where it is envisaged that greater mechanical strength may be needed.

In the embodiment of Figure 8, the locking member 62 is substantially trapezoidal in shape when viewed from above the major surface. Since the shape of opening 64 in this example conforms to the shape of the locking member 62, the opening itself is also substantially trapezoidal in shape when viewed from above the major surface. However, it is envisaged that the locking member 62 and/or the opening 64 may have an alternative shape. Some further embodiments are described below in relation to Figures 9A-9C.

In some embodiments (includes those shown in Figures 9A-9C), the locking member may have edges that are curved when viewed from above the major surface.

The dielectric partition 12 shown in Figure 9A forms an interlocking portion 60 which has a substantially circular head portion 68. At its widest point (which may be considered to be the diameter of the substantially circular head portion 68 in this embodiment), the head portion 68 is wider than the narrowest part of the neck portion 66 when viewed from above the major surface of the substrate. Since the shape of the opening 64 confirms with the shape of the head portion 62, the shape of the opening 64 in this example is also substantially circular. In this embodiment also, the widest point of the head portion 68 may be at least as wide as (or in some embodiments, wider than) the width of the mouth portion 67 of the opening 64, to assist in retaining the locking member 62 within the opening 64.

The dielectric partition 12 shown in Figure 9B forms an interlocking portion 60 which has a locking member 62 with head portion 68 having a substantially flat top part and a pinched neck portion 66 (resembling the shape of an hourglass). The shape of the opening 64 is similar to that of the head portion 62 in this example. At its widest point, the head portion 68 is wider than the narrowest part of the pinched neck portion 66 when viewed from above the major surface of the substrate. In this embodiment also, the widest point of the head portion 68 may be at least as wide as (or in some examples, wider than) the width of the mouth portion 67 of the opening 64, to assist in retaining the locking member 62 within the opening 64.

The dielectric partition 12 shown in Figure 9C forms an interlocking portion 60 which has a locking member 62 which is shaped similarly to that shown in Figure 9B, with the exception that instead of having a substantially flat top part, the locking member 62 has a concave top part. This may increase the surface area of the locking member 62, which may improve the mechanical strength of the interlocking portion 60. Again, the shape of the opening 64 in this embodiment conforms with that of the head portion 62. At its widest point, the head portion 68 is wider than the narrowest part of the pinched neck portion 66 when viewed from above the major surface of the substrate. In this embodiment also, the widest point of the head portion 68 may be at least as wide as (or in some embodiments, wider than) the width of the mouth portion 67 of the opening 64, to assist in retaining the locking member 62 within the opening 64.

It is envisaged that a given device 10 of the kind described herein need not include interlocking portions 60 all having the same size and/or shape. For instance, a given device 10 may include interlocking portions 60 having a mixture of shapes of the kind described in relation to Figures 8 and 9A-9C.

With reference to the method described in relation to Figures 5A-5C, it will be appreciated that the locking portions 60 described herein may be formed by appropriate shaping of the trench(es) 110 shown in Figure 5A. As mentioned previously, the trench(es) 110 may be formed lithographically, or may be for instance be formed by laser etching. Either of these techniques would be suitable for appropriately shaping the trench(es) 110 so that filling of the trench(es) 110 with dielectric as shown in Figure 5B and singulation of the wafer 102 as shown in Figure 5C may result in a device 10 having dielectric partition(s) 12 with interlocking portion(s) 60 of the kind described above.

Accordingly, there has been described a semiconductor device and a method of making the same.

Although particular embodiments of this disclosure have been described, it will be appreciated that many modifications/additions and/or substitutions may be made within the scope of the claims.

## Claims

1. A semiconductor device comprising:
a substrate (2) comprising a major surface and a backside;
one or more electrical contacts located on the major surface; and
a dielectric partition (12) for electrically isolating a first part (30) of the substrate from a second part (40) of the substrate, wherein the dielectric partition (12) extends through the substrate (2) from the major surface to the backside,
**characterized in that**: the dielectric partition (12) includes at least one corner when viewed from above the major surface of the substrate, (2); and the dielectric partition (12) is shaped to define at least one interlocking portion in the substrate, wherein the interlocking portion comprises a locking member (62) located on one side of the dielectric partition and an opening (64) located on an opposite side of the dielectric partition, wherein the locking member (62) is received within the opening (64) and is conformal therewith to inhibit physical separation of the first (30) and second (40) parts of the substrate that the dielectric partition (12) electrically isolates.

2. The semiconductor device of claim 1, wherein the first part (30) of the substrate includes an active region of the semiconductor device and wherein the second part (40) of the substrate includes a sidewall of the substrate that extends between the major surface and the backside.

3. The semiconductor device of claim 1, wherein the first part (30) of the substrate includes a first active region of the semiconductor device and wherein the second part (40) of the substrate includes a second active region of the semiconductor device.

4. The semiconductor device of claim 1, wherein the locking member (62) of the at least one interlocking portion includes a neck portion (66) and a head portion (68), wherein the opening (64) includes a mouth portion (67) within which the neck portion (66) of the locking member is received, and wherein the head portion (68) of the locking member is at least as wide as the mouth portion (67) of the opening when viewed from above the major surface, to prevent removal of the head portion (68) from the opening.

5. The semiconductor device of claim 4, wherein the locking member (62) is substantially trapezoidal in shape when viewed from above the major surface.

6. The semiconductor device of any of claims 1 to 5, wherein edges of the locking member (62) are curved when viewed from above the major surface.

7. The semiconductor device of any of claims 1 to 6, wherein the dielectric partition (12) includes a plurality of said interlocking portions.

8. The semiconductor device of any preceding claim comprising at least one further dielectric partition (12), when at least some of the dielectric partitions intersect.

9. The semiconductor device of any preceding claim, wherein the substrate includes at least one further part, and wherein the first part (30), the second part (40) and each further part of the substrate are electrically isolated from neighbouring parts by one or more said dielectric partitions (12).

10. A chip scale package comprising the semiconductor device of any preceding claim.

11. A method of making a semiconductor device, the method comprising:
providing a wafer (102) having a major surface and a backside;
forming a trench (110) that extends from the major surface at least partially through the wafer (102);
at least partially filling the trench with dielectric;
forming a plurality of electrical contacts on the major surface;
removing material from the backside of the wafer at least until a bottom of the trench (110) is exposed; and
singulating the wafer to form a plurality of semiconductor substrates (2), wherein at least one of the substrates includes a dielectric partition (12,112) formed from the dielectric filled trench, wherein the dielectric partition (12,112) electrically isolates a first part (30) of the substrate from a second part (40) of the substrate, and
wherein the dielectric partition (12,112) includes at least one corner when viewed from above the major surface of the substrate (2), wherein the dielectric partition (12,112) is shaped to define at least one interlocking portion in the substrate, wherein the interlocking portion comprises a locking member (62) located on one side of the dielectric partition (12,112) and an opening (64) located on an opposite side of the dielectric partition, wherein the locking member (62) is received within the opening (64) and is conformal therewith to inhibit physical separation of the first (30) and second (40) parts of the substrate that the dielectric partition (12,112) electrically isolates.

12. The method of claim 11, wherein the first part (30) of the at least one of the substrates (2) includes an active region of the semiconductor device and wherein the second part (40) of the substrate includes a sidewall of the substrate that extends between a major surface and a backside of the substrate corresponding to the major surface and backside of the wafer.

## Patentansprüche

1. Hableitervorrichtung, die Folgendes umfasst:
ein Substrat (2), umfassend eine Hauptoberfläche und eine Rückseite;
einen oder mehrere auf der Hauptoberfläche befindliche elektrische Kontakte; und
eine dielektrische Unterteilung (12) zum elektrischen Isolieren eines ersten Teils (30) des Substrats von einem zweiten Teil (40) des Substrats, wobei sich die dielektrische Unterteilung (12) von der Hauptoberfläche zu der Rückseite durch das Substrat (2) erstreckt,
**dadurch gekennzeichnet, dass**: die dielektrische Unterteilung (12) bei Betrachtung von oberhalb der Hauptoberfläche des Substrats (2) mindestens eine Ecke umfasst; und
die dielektrische Unterteilung (12) geformt ist, um mindestens einen Verzahnungsabschnitt in dem Substrat zu definieren, wobei der Verzahnungsabschnitt ein auf einer Seite der dielektrischen Unterteilung befindliches Verriegelungselement (62) und eine auf einer gegenüberliegenden Seite der dielektrischen Unterteilung befindliche Öffnung (64) umfasst, wobei das Verriegelungselement (62) in der Öffnung (64) aufgenommen ist und damit gleichförmig ist, um die physische Trennung des ersten (30) und des zweiten (40) Teils des Substrats, die die dielektrische Unterteilung (12) elektrisch isoliert, zu hemmen.

2. Halbleitervorrichtung nach Anspruch 1, wobei der erste Teil (30) des Substrats einen aktiven Bereich der Halbleitervorrichtung umfasst und wobei der zweite Teil (40) des Substrats eine Seitenwand des Substrats umfasst, die sich zwischen der Hauptoberfläche und der Rückseite erstreckt.

3. Halbleitervorrichtung nach Anspruch 1, wobei der erste Teil (30) des Substrats einen ersten aktiven Bereich der Halbleitervorrichtung umfasst und wobei der zweite Teil (40) des Substrats einen zweiten aktiven Bereich der Halbleitervorrichtung umfasst.

4. Halbleitervorrichtung nach Anspruch 1, wobei das Verriegelungselement (62) des mindestens einen Verzahnungsabschnitts einen Halsabschnitt (66) und einen Kopfabschnitt (68) umfasst, wobei die Öffnung (64) einen Mündungsabschnitt (67) umfasst, in dem der Halsabschnitt (66) des Verriegelungselements aufgenommen ist, und wobei bei Betrachtung von oberhalb der Hauptoberfläche der Kopfabschnitt (68) des Verriegelungselements mindestens so breit ist wie der Mündungsabschnitt (67), um das Entfernen des Kopfabschnitts (68) aus der Öffnung zu verhindern.

5. Halbleitervorrichtung nach Anspruch 4, wobei das Verriegelungselement (62) bei Betrachtung von oberhalb der Hauptoberfläche eine im Wesentlichen trapezförmige Form aufweist.

6. Halbleitervorrichtung nach einem der Ansprüche 1 bis 5, wobei bei Betrachtung von oberhalb der Hauptoberfläche Kanten des Verriegelungselements (62) gekrümmt sind.

7. Halbleitervorrichtung nach einem der Ansprüche 1 bis 6, wobei die dielektrische Unterteilung (12) eine Vielzahl der Verzahnungsabschnitte umfasst.

8. Halbleitervorrichtung nach einem der vorangehenden Ansprüche, umfassend mindestens eine weitere dielektrische Unterteilung (12), wenn sich mindestens einige der dielektrischen Unterteilungen kreuzen.

9. Halbleitervorrichtung nach einem der vorangehenden Ansprüche, wobei das Substrat mindestens einen weiteren Teil umfasst und wobei der erste Teil (30), der zweite Teil (40) und jeder weitere Teil des Substrats durch die eine oder die mehreren dielektrischen Unterteilungen (12) von benachbarten Teilen elektrisch isoliert sind.

10. Chip-Scale-Gehäuse, das die Halbleitervorrichtung nach einem der vorangehenden Vorrichtung umfasst.

11. Verfahren zum Herstellen einer Halbleitervorrichtung, wobei das Verfahren Folgendes umfasst:
Bereitstellen eines Wafers (102), der eine Hauptoberfläche und eine Rückseite aufweist;
Bilden eines Grabens (110), der sich von der Hauptoberfläche mindestens teilweise durch den Wafer (102) erstreckt;
mindestens teilweise Füllen des Grabens mit Dielektrikum;
Bilden einer Vielzahl von elektrischen Kontakten auf der Hauptoberfläche;
Entfernen von Material von der Rückseite des Wafers, mindestens bis ein Boden des Grabens (110) freigelegt ist; und
Vereinzeln des Wafers, um eine Vielzahl von Halbleitersubstraten (2) zu bilden, wobei mindestens eines der Substrate eine aus dem mit Dielektrikum gefüllten Graben gebildete dielektrische Unterteilung (12, 112) umfasst, wobei die dielektrische Unterteilung (12, 112) einen ersten Teil (30) des Substrats von einem zweiten Teil (40) des Substrats elektrisch isoliert, und wobei die dielektrische Unterteilung (12, 112) bei Betrachtung von oberhalb der Hauptoberfläche des Substrats (2) mindestens eine Ecke umfasst, wobei die dielektrische Unterteilung (12, 112) geformt ist, um mindestens einen Verzahnungsabschnitt in dem Substrat zu definieren, wobei der Verzahnungsabschnitt ein auf einer Seite der dielektrischen Unterteilung (12, 112) befindliches Verriegelungselement (62) und eine auf einer gegenüberliegenden Seite der dielektrischen Unterteilung befindliche Öffnung (64) umfasst, wobei das Verriegelungselement (62) in der Öffnung (64) aufgenommen ist und damit gleichförmig ist, um die physische Trennung des ersten (30) und des zweiten (40) Teils des Substrats, die die dielektrische Unterteilung (12, 112) elektrisch isoliert, zu hemmen.

12. Verfahren nach Anspruch 11, wobei der erste Teil (30) des mindestens einen der Substrate (2) einen aktiven Bereich der Halbleitervorrichtung umfasst und wobei der zweite Teil (40) des Substrats eine Seitenwand des Substrats umfasst, die sich zwischen einer Hauptoberfläche und einer Rückseite des Substrats, die der Hauptoberfläche und der Rückseite des Wafers entsprechen, erstreckt.

## Revendications

1. Dispositif semi-conducteur comprenant :
un substrat (2) comprenant une surface principale et un dos ;
un ou plusieurs contacts électriques situés sur la surface principale ; et
une cloison diélectrique (12) destinée à isoler électriquement une première partie (30) du substrat d'une seconde partie (40) du substrat, la cloison diélectrique (12) s'étendant à travers le substrat (2) depuis la surface principale vers le dos,
**caractérisé en ce que** : la cloison diélectrique (12) inclut au moins un angle lorsqu'elle est vue depuis le dessus de la surface principale du substrat (2) ; et
la cloison diélectrique (12) est mise en forme de sorte à délimiter au moins une partie d'emboîtement dans le substrat, la partie d'emboîtement comprenant un élément de verrouillage (62) situé sur un côté de la cloison diélectrique et une ouverture (64) située sur un côté opposé de la cloison diélectrique, l'élément de verrouillage (62) étant reçu à l'intérieur de l'ouverture (64) et étant conforme à celle-ci afin d'empêcher une séparation physique des première (30) et seconde (40) parties du substrat que la cloison diélectrique (12) isole électriquement.

2. Dispositif semi-conducteur selon la revendication 1, la première partie (30) du substrat incluant une région active du dispositif semi-conducteur et la seconde partie (40) du substrat incluant une paroi latérale du substrat qui s'étend entre la surface principale et le dos.

3. Dispositif semi-conducteur selon la revendication 1, la première partie (30) du substrat incluant une première région active du dispositif semi-conducteur et la seconde partie (40) du substrat incluant une seconde région active du dispositif semi-conducteur.

4. Dispositif semi-conducteur selon la revendication 1, l'élément de verrouillage (62) de la au moins une partie d'emboîtement comprenant une partie col (66) et une partie tête (68), l'ouverture (64) incluant une partie bouche (67) à l'intérieur de laquelle la partie col (66) de l'élément de verrouillage est reçue, et la partie tête (68) de l'élément de verrouillage étant au moins aussi large que la partie bouche (67) de l'ouverture lorsqu'on regarde depuis le dessus de la surface principale, afin d'empêcher un retrait de la partie tête (68) de l'ouverture.

5. Dispositif semi-conducteur selon la revendication 4, l'élément de verrouillage (62) étant de forme sensiblement trapézoïdale lorsqu'il est regardé depuis le dessus de la surface principale.

6. Dispositif semi-conducteur selon l'une quelconque des revendications 1 à 5, des bords de l'élément de verrouillage (62) étant courbes lorsqu'il est regardé depuis le dessus de la surface principale.

7. Dispositif semi-conducteur selon l'une quelconque des revendications 1 à 6, la cloison diélectrique (12) incluant une pluralité desdites parties d'emboîtement.

8. Dispositif semi-conducteur selon l'une quelconque des revendications précédentes, comprenant au moins une autre cloison diélectrique (12), lorsque au moins certaines des cloisons diélectriques se coupent.

9. Dispositif semi-conducteur selon l'une quelconque des revendications précédentes, le substrat incluant au moins une partie supplémentaire, et la première partie (30), la seconde partie (40) et chaque partie supplémentaire du substrat étant électriquement isolée des parties voisines par une ou plusieurs desdites cloisons diélectriques (12).

10. Conditionnement à échelle d'une puce comprenant le dispositif semi-conducteur selon l'une quelconque des revendications précédentes.

11. Procédé de fabrication d'un dispositif semi-conducteur, le procédé comprenant les étapes consistant à :
fournir une tranche (102) ayant une surface principale et un dos ;
former une tranchée (110) s'étendant de la surface principale au moins en partie à travers la tranche (102) ;
au moins en partie remplir la tranchée avec un diélectrique ;
former une pluralité de contacts électriques sur la surface principale ;
retirer du matériau du dos de la tranche au moins jusqu'à ce qu'un fond de la tranchée (110) soit exposé ; et
individualiser la tranche pour former une pluralité de substrats semiconducteurs (2),
dans lequel
au moins l'un des substrats inclut une cloison diélectrique (12, 112) formée à partir de la tranchée remplie de diélectrique, la cloison diélectrique (12, 112) isolant électriquement une première partie (30) du substrat d'une seconde partie (40) du substrat, et la cloison diélectrique (12, 112) incluant au moins un angle lorsqu'elle est regardée depuis le dessus de la surface principale du substrat (2), la cloison diélectrique (12, 112) étant formée de sorte à délimiter au moins une partie d'emboîtement dans le substrat, la partie d'emboîtement comprenant un élément de verrouillage (62) situé sur un côté de la cloison diélectrique (12, 112) et une ouverture (64) située sur un côté opposé de la cloison diélectrique, l'élément de verrouillage (62) étant reçu à l'intérieur de l'ouverture (64) et étant conforme à celle-ci pour empêcher une séparation physique des première (30) et seconde (40) parties du substrat que la cloison diélectrique (12, 112) isole électriquement.

12. Procédé selon la revendication 11, la première partie (30) du au moins un des substrats (2) incluant une région active du dispositif semi-conducteur et la seconde partie (40) du substrat incluant une paroi latérale du substrat qui s'étend entre une surface principale et un dos du substrat correspondant à la surface principale et au dos de la tranche.
